# EUROPÄISCHE PATENTSCHRIFT

(11) **EP 0 441 129 B1**
(45) Veröffentlichungstag und Bekanntmachung des Hinweises auf die Patenterteilung: **20.11.1996**
(21) Anmeldenummer: 91100315.0
(22) Anmeldetag: 11.01.1991
(51) Int. Cl.: H03M 11/20

(54) **Schaltungsanordnung zur Abfrage einer Tastatur**
Keyboard sensing circuit
Circuit de scrutation de clavier

(30) Priorität: 18.01.1990 DE 4001269
(43) Veröffentlichungstag der Anmeldung: 14.08.1991
(73) Patentinhaber: DEUTSCHE THOMSON-BRANDT GMBH, 78048 Villingen-Schwenningen (DE)
(72) Erfinder: Füldner, Friedrich, W-7730 Villingen-Schwenningen (DE); Baas, Dieter, W-7640 Kehl-Auenheim (DE)
(74) Vertreter: Einsel, Robert, Dipl.-Ing.

(56) Entgegenhaltungen:
- DE-C- 3 315 683
- US-A- 4 673 933
- PATENT ABSTRACTS OF JAPAN Bd. 7, Nr. 172 (P-213)[1317] 29. Juli 1983 & JP-A-58 78 224
- ELECTRONIC DESIGN, Bd. 26, Nr. 25., 6. Dezember 1978, S. 120, Rochelle Park, US; G. BUURMA: "Expand a keyboard matrix by adding isolation diodes to a key encoder"

## Beschreibung

Die Erfindung betrifft eine Schaltungsanordnung zur Abfrage einer Tastatur. Zur Einsparung von Leitungen wird eine Tastatur von matrixartig angeordneten Reihen- und Spaltenleitungen abgefragt, deren Kreuzungspunkte bei der Betätigung von Tasten der Tastatur elektrisch verbunden werden. Dazu werden auf die eine Gruppe der Leitungen zyklisch auftretende Abfrageimpulse gegeben, die über die Tastenkontakte auf die andere Gruppe der Leitungen an eine Auswerteschaltung gelangen. Auf diese Weise kann eine Tastatur mit m Reihenleitungen und n Spaltenleitungen aus m mal n Tasten aufgebaut werden. Die Anzahl der erzielbaren Tasten ist demnach von der Anzahl der von der Auswerteschaltung zur Verfügung gestellten Leitungen abhängig.

Aus der DE 33 15 683 ist C1 eine Schaltungsanordnung zur Abfrage einer Tastatur bekannt, die einen Mikroprozessor mit 2 Gruppen von abwechselnd als Ein- und Ausgänge geschalteten I/O - Ports enthält, und in der die Tasten durch zyklische Impulse abgefragt werden. Bei dieser Schaltungsanordung wird die Tastenzahl der Tastatur bei gleicher Anzahl von Leitungen verdoppelt. Eine vergleichbare Anordnung wurde in JP-A-58 078 224 veroffentlicht.

Der Erfindung liegt die Aufgabe zugrunde, bei gleicher Anzahl von Leitungen die verfügbare Tastenanzahl einer Tastatur zu vervierfachen, d.h. bei Vorhandensein von m Reihenleitungen und n Spaltenleitungen 4 (m x n) Tasten zu ermöglichen. Diese Aufgabe wird durch die im Patentanspruch 1 angegebene Erfindung gelöst.

Nachfolgend wird die Erfindung an einem Ausführungsbeispiel mit Hilfe der Zeichnung erläutert.
- Figur 1: zeigt eine bekannte Ausführungsform
- Figur 2: zeigt die zur Erläuterung der Wirkungsweise der Schaltung nach Figur 1 erforderlichen Signale
- Figur 3: zeigt eine zweite bekannte Ausführungsform
- Figur 4: zeigt die sich auf Figur 3 beziehenden Signale
- Figur 5: zeigt eine erfindungsgemäße weitere Verdoppelung der Tastenkontakte
- Figur 6: zeigt ein Diagramm zur Erläuterung der Figur 5

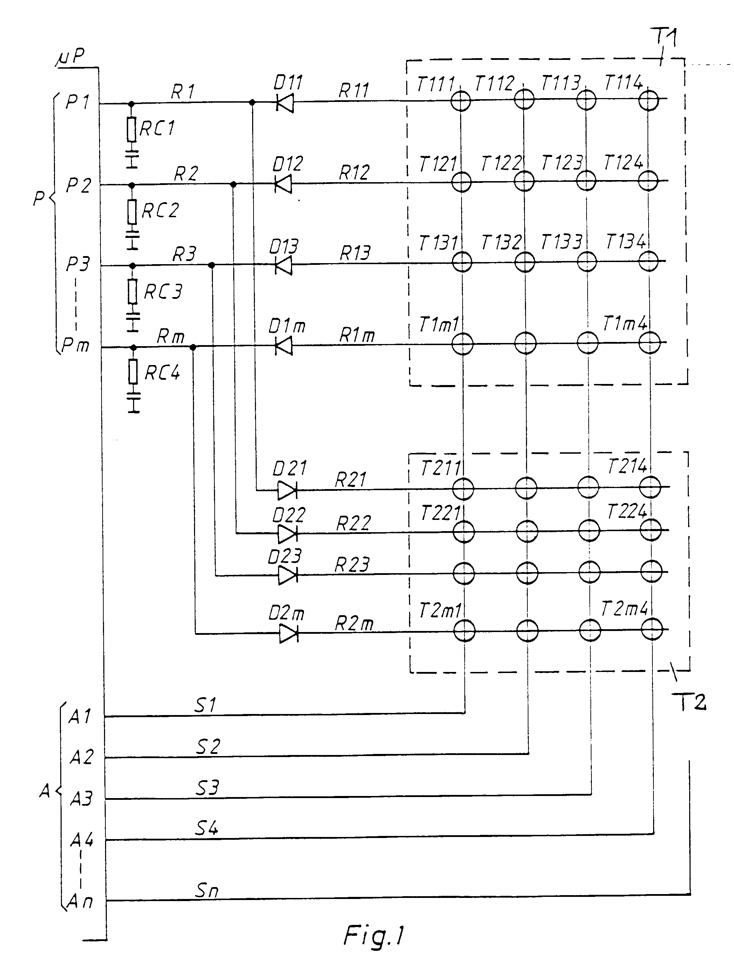

Zunächst wird mit Hilfe der Figur 1 ein bekanntes Ausführungsbeispiel beschrieben, bei welchem angenommen wird, daß es sich um eine Anordnung aus m=3 Reihenleitungen und n=4 Spaltenleitungen handelt. Üblicherweise können hiermit 3x4=12 Tasten abgefragt werden und es wird nachfolgend beschrieben, wie eine Tastatur mit 24 Tasten realisiert werden kann.

Der Mikroprozessor uP besitzt in diesem Fall drei I/O-Ports P (P1, P2, P3), an welche die Reihenleitungen R1, R2 und R3 angeschlossen sind. An den Ports P1, P2 und P3 liegen RC-Glieder RC1, RC2 und RC3, so daß die Ausgangspotentiale hoch oder niedrig geschaltet werden können. Das Tastenfeld T besteht aus einer ersten Tastengruppe T1 mit den Tasten T111 bis T134 und aus einer zweiten Tastengruppe T2 mit den Tasten T211 bis T234, welche die Reihenleitungen R mit den Spaltenleitungen S verbinden, die mit Ausgangsports A des Mikroprozessors uP verbunden sind.

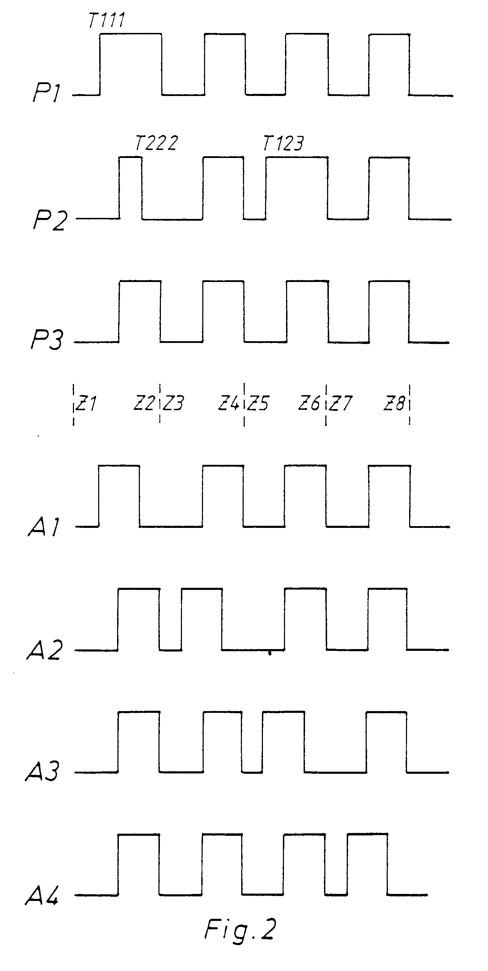

Die Wirkungsweise der Schaltung nach Figur 1 wird mit Hilfe der Signale der Figur 2 beschrieben. Die Ausgänge P1 bis P3 laden die Kondensatoren C1, C2 und C3 der RC-Glieder auf ein Potential auf und entladen diese wieder auf Bezugspotential, wie in Figur 2 gezeigt, so daß während der Zyklen Z1, Z3, Z5, Z7 die Ports P auf niedrigem Potential liegen, während der Zyklen Z2, Z4, Z6 und Z8 liegen diese auf hohem Potential. Die Abfrage der Tasten T111 bis T234 geschieht dadurch, daß von den Ausgängen A1 bis A4 Signale gemäß Figur 2 auf die Spaltenleitungen S1 bis S4 gegeben werden. Die Reihenleitungen R1 bis R3 sind einerseits über Dioden D11, D12, D13 auf die Reihenleitungen R11, R12 und R13 der Tastengruppe T1 und andererseits über entgegengesetzt gepolte Dioden D21, D22, D23 auf die Reihenleitungen R21, R22 und R23 des Tastengruppe T2 geschaltet. Die Abfrageimpulse der Ausgänge A1 bis A4 sind derart ausgebildet, daß in einem ersten Zyklus Zn einer Spalte S der hohe Potentialanteil und in einem nachfolgenden Zyklus Zn+1 der Spalte der niedrige Potentialanteil eines Ausgangs A zugeführt wird. So zeigt z.B. die Figur 2, daß im Zyklus Z1 bei der Abfrage der Spalte S1 die Taste T111 betätigt ist, weil der als Eingang geschaltete Port P1 einen positiven Potentialsprung erfährt, und daß im nachfolgenden Zyklus Z2 bei der Abfrage der Spalte S1 die Taste T222 betätigt ist, weil der als Eingang geschaltete Port P2 einen negativen Potentialsprung erfährt und daß im Zyklus Z5 bei der Abfrage der Spalte S3 die Taste T 123 betätigt ist, weil diese auf dem als Eingang geschalteten Port P2 einen positiven Potentialsprung bewirkt.

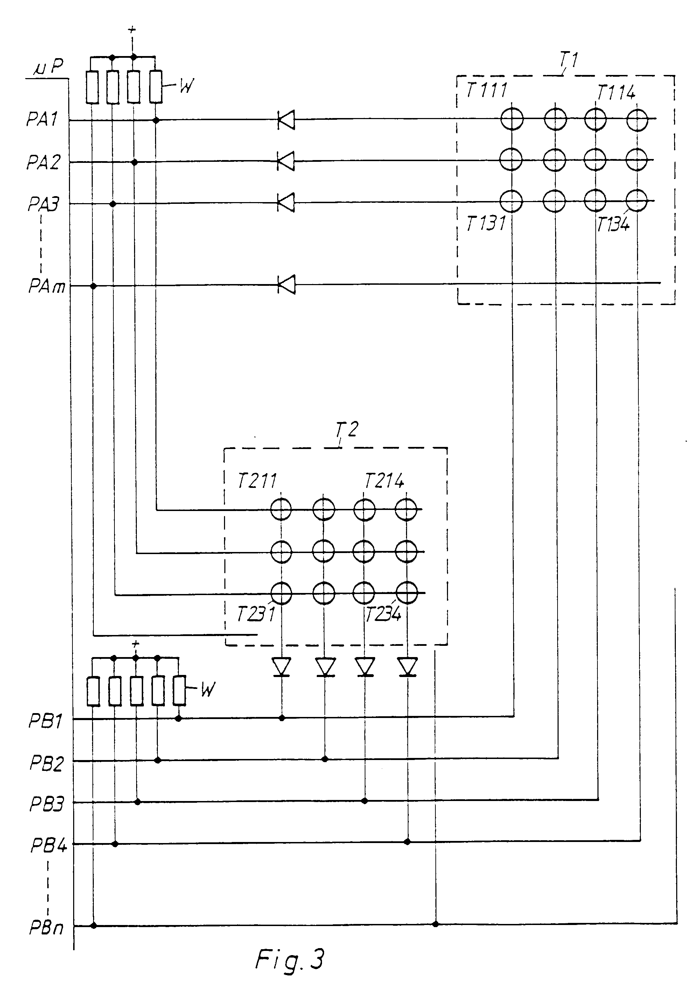

In Figur 3 ist eine weitere bekannte Schaltung gezeigt. Der Mikroprozessor uP besitzt Ein/Ausgänge (I/O-Ports) PA und PB zur Abgabe und zum Empfang von Steuersignalen auf den Leitungen R und S. Eine erste Tastengruppe T1 mit den Tasten T111 bis T134 verbindet die Reihenleitungen R11 bis R13 mit den Spaltenleitungen S1 bis S4. Die Reihenleitungen R11 bis R13 sind über in Durchlaßrichtung gepolte Dioden D11 bis D13 mit den Ports PA1 bis PA3 verbunden. Die Spaltenleitungen S1 bis S4 sind mit den Ports PB1 bis PB4 des Mikroprozessors uP verbunden.

Eine zweiten Tastengruppe T2 mit den Tasten T211 bis T234 verbindet die Reihenleitungen R21 bis R23 mit den Spaltenleitungen S1 bis S4. Die Spaltenleitungen S1 bis S4 sind über in Durchlaßrichtung gepolte Dioden D21 bis D24 mit dem Ports PB1 bis PB4 des Mikroprozessors uP verbunden. Die Reihenleitungen R21 bis R23 sind mit den Ports PA1 bis PA3 des Mikroprozessors uP verbunden. Während der Abfrage der Tastengruppe T1 sind die Ports PA1 bis PAm als Ausgänge und die Ports PB1 bis PBn als Eingänge geschaltet.

Während der Abfrage der Tastengruppe T2 sind die Ports PB1 bis PBn als Ausgänge und die Ports PA1 bis PAm als Eingänge geschaltet.

Zur Abfrage der Tasten werden die als Ausgänge geschalteten Ports jeweils auf Massepotential gelegt, während die übrigen Ports durch die Pull-up-Widerstände W auf ein hohes Potential gelegt sind. Das Massepotential wird über die Dioden D an den jeweils als Eingang geschalteten Port gelegt.

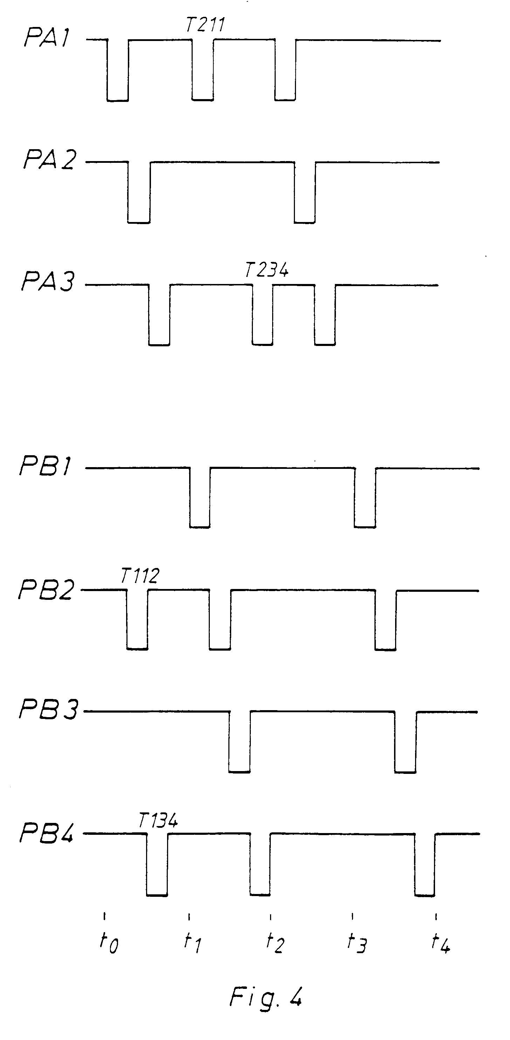

In Figur 4 sind die Signale auf den Leitungen R1 bis R3 und S1 bis S4 dargestellt in Verbindung mit den Zuständen der Ports PA1 bis PA3 und PB1 bis PB4, je nachdem ob sie als Ein- oder Ausgänge geschaltet sind. Es sind die Signale eingetragen, die an den jeweiligen Eingängen des Mikroprozessors uP entstehen, z.B. bei Betätigung der Tasten T122, T134, T211 oder T234. In der Zeitspanne t0 bis t1 sind die Ports PA1 bis PA3 als Ausgänge und die Ports PB1 bis PB4 als Eingänge geschaltet. In der Zeitspanne von t1 bis t2 sind die Ports PB1 bis PB4 als Ausgänge und die Ports PA1 bis PA3 als Eingänge geschaltet, was sich in den Zeitspannen t2 bis t3, t3 bis t4 usw. alternierend wiederholt.

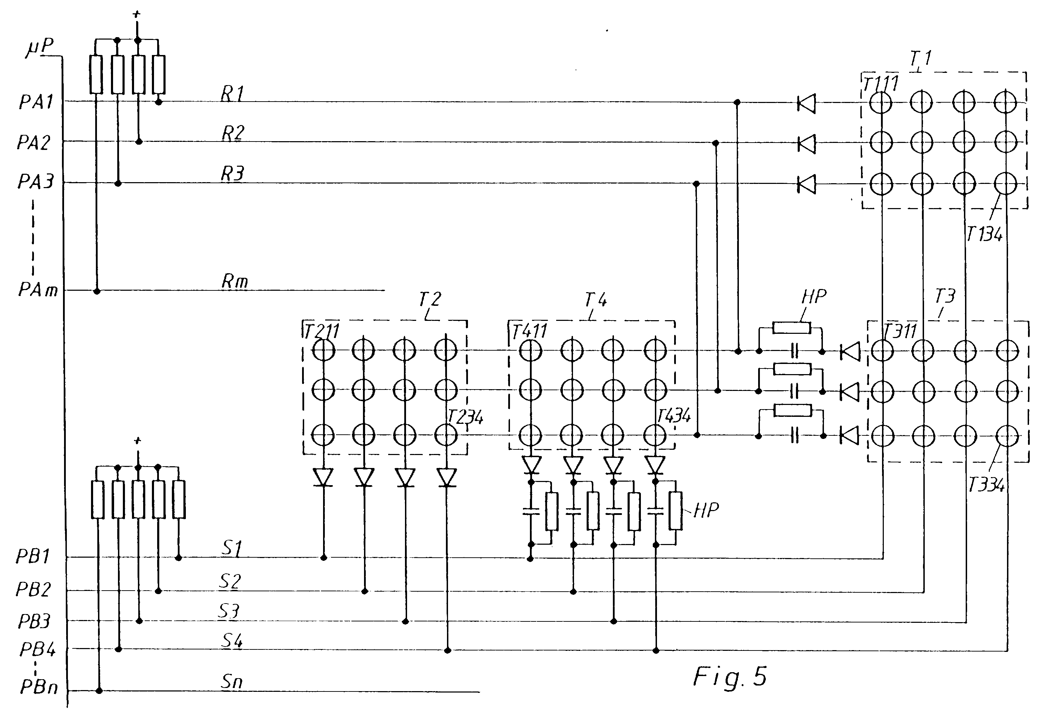

Die Schaltung läßt sich erfindungsgemäß nochmals auf die doppelte Anzahl von Tasten erweitern, wenn die Schaltung nach Figur 3 in der nach Figur 5 dargestellten Weise ergänzt wird, ohne daß auch hier mehr Leitungen bzw. Ports des Mikroprozessors benötigt werden.

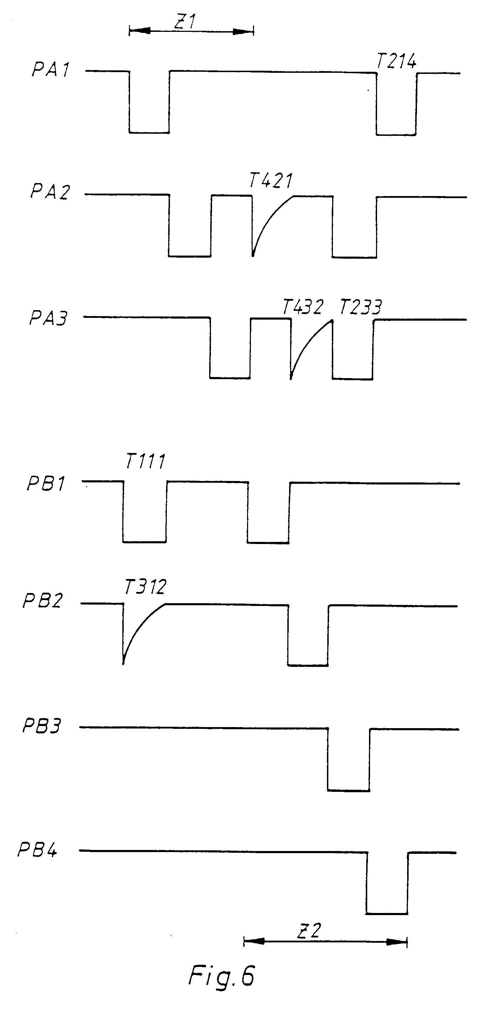

Man erkennt wieder die beiden Tastengruppen T1 und T2 mit den Tasten T111 bis T134 und T211 bis T234. Hinzukommen zwei weitere Tastengruppen T3 und T4 mit den Tasten T311 bis T334 und T411 bis T434. Die Spaltenleitungen S1 bis S4 der Tastengruppe T1 sind mit den Spaltenleitungen der Tastengruppe T3 und die Reihenleitungen R1 bis R3 der Tastengruppe T2 sind mit den Reihenleitungen der Tastengruppe T4 verbunden. Auch bei dieser Anordnung sind die Ports PA und PB des Mikroprozessors abwechselnd als Ein- und Ausgänge geschaltet. Die Tasten der Tastenfelder T3 und T4 sind über Hochpaßglieder HP mit den Ports verbunden. Der Zweck dieser Hochpaßglieder wird nachfolgend beschrieben. Sie dienen dazu, daß die beiden Tastengruppen T1/T3 bzw. T2/T4 bei der Abfrage unterscheidbar werden, wie nachstehend mit Hilfe der Figur 6 näher erläutert wird.

Während der Dauer Z1 sind die Ports PB und während der Dauer Z2 die Ports PA als Eingänge für die Tastengruppen T1/T3 bzw. T2/T4 geschaltet. Das Kriterium zur Unterscheidung bei der Abfrage der Tastengruppen T1/T3 bzw. T2/T4 ist dadurch gekennzeichnet, daß bei den Tastengruppen T3 und T4 mit den Hochpaßgliedern HP während des Abfrageimpulses nur zu Beginn ein Signal auftritt, welches nach einer e-Funktion abklingt. Wenn also während der gesamten Abfragezeit ein Signal vorhanden ist, handelt es sich um eine Taste T3xy der Tastengruppe T3 oder um eine Taste T4xy der Tastengruppe T4, andernfalls um eine Taste der Tastengruppen T1 oder T2. In dem Diagramm nach Figur 6 sind als Beispiel die Tasten T111, T312, T421, T214, T432 und T233 betätigt.
Wenn die einzelnen Tatengruppen elektrisch voneinander getrennt sind, so bedeutet dies nicht, daß sie auch mechanisch voneinander getrennt sein müssen, sondern daß diese für den Bedienenden absolut eine optische Einheit bilden können.

## Patentansprüche

1. Schaltungsanordnung zur Abfrage einer Tastatur, deren Tasten bei Betätigung matrixartig angeordnete Spaltenleitungen und Reihenleitungen miteinander verbinden, die mit zwei Gruppen von I/O - Ports (PA, PB) eines Mikroprozessors (uP) verbunden sind, wobei diese im Gegentakt abwechselnd als Ein- und Ausgänge geschaltet sind, und wobei die jeweils als Eingänge geschalteteten Ports (PA bzw. PB) die von den jeweils als Ausgänge geschalteten Ports (PB bzw. PA) abgegebenen Abfrageimpulse für die Tastengruppen auswerten und der Mikroprozessor (uP) aus der Koinzidenz eines zyklisch an den Ausgängen des Mikroprozessors stehenden Abfrageimpulses mit einem aktivierten Eingang des Mikroprozessors die momentan betätigte Taste identifiziert, **dadurch gekennzeichnet**,
daß die Tastatur (T) in vier Tastengruppen (T1, T3; T2, T4) aufgeteilt ist, welche von den Ein- und Ausgängen (PA, PB) des Mikroprozessors abgefragt werden,
daß die ersten beiden Tastengruppen (T1, T3) mit ihren Tasten (T111 bis T1 mn, T311 bis Tmn) mit ihren Reihenleitungen (R1, bis Rm) über in Durchlaßrichtung gepolte Dioden mit der ersten Gruppe von I/O-Ports (PA1, PA2 bis PAm) und mit ihren Spaltenleitungen (S1 bis Sn) mit der zweiten Gruppe von I/O-Ports (PB1, PB2 bis PBn) verbunden sind,
daß an die erste Gruppe von I/O-Ports (PA1, PA2 bis PAm) die Reihenleitungen (R1, bis Rm) der zwei weiteren Tastengruppen (T2, T4) mit ihren Tasten (T211, T212 bis T2mn und T411, T412 bis T4mn) geschaltet sind, deren Spaltenleitungen (S1, bis Sn) über in Durchlaßrichtung gepolte Dioden mit der zweiten Gruppe von I/O-Ports (PB1, PB2 bis PBn) verbunden sind,
und daß die erste Tastengruppe (T1) und die dritte Tastengruppe (T3) und die zweite (T2) und die vierte Tastengruppe (T4) parallel geschaltet sind, wobei in die Reihenleitungen (R) der dritten Tastengruppe (T3) und in die Spaltenleitungen (S) der vierten Tastengruppe (T4) Mittel (HP) geschaltet sind.

2. Schaltungsanordnung nach Anspruch 1, **dadurch gekennzeichnet,** daß die Mittel zur Unterscheidung der Tastengruppen durch Hochpässe ausgebildet werden.

## Claims

1. Circuit arrangement for interrogating a keyboard whose keys connect together row leads and column leads arranged in the form of a matrix when they are actuated, the leads being connected to two groups of I/O ports (PA, PB) of a microprocessor (µP), wherein the ports are alternately connected up in push-pull manner as inputs and outputs and wherein the ports (PA or PB) that are currently connected up as inputs evaluate the interrogating pulses emitted by the ports (PB or PA) that are currently connected up as outputs for the groups of keys and the microprocessor (µP) identifies the currently actuated key from the coincidence of an interrogating pulse that is applied cyclically to the output of the microprocessor with an activated input of the microprocessor, characterised in
that the keyboard (T) is divided into four groups of keys (T1, T3; T2, T4) which are interrogated by the inputs and outputs (PA, PB) of the microprocessor,
that the first two groups of keys (T1, T3) with their keys (T111 to T1mn, T311 to Tmn) are connected by their row leads (R1, to Rm) to the first group of I/O ports (PA1, PA2 to PAm) via diodes that are poled in the forward direction and by their column leads (S1 to Sn) to the second group of I/O ports (PB1, PB2 to PBn),
that the row leads (R1, to Rm) of the two further groups of keys (T2, T4) with their keys (T211, T212 to T2mn and T411, T412 to T4mn) are connected to the first group of I/O ports (PA1, PA2 to PAm) while their column leads (S1, to Sn) are connected to the second group of I/O ports (PB1, PB2 to PBn) via diodes that are poled in the forward direction,
and that the first group of keys (T1) and the third group of keys (T3) and the second (T2) and the fourth group of keys (T4) are connected in parallel, wherein means (HP) are connected in the row leads (R) of the third group of keys (T3) and in the column leads (S) of the fourth group of keys (T4).

2. Circuit arrangement in accordance with Claim 1, characterised in that, the means for distinguishing between the groups of keys are formed by high pass filters.

## Revendications

1. Circuit de scrutation de clavier dont les touches sont reliées lors de leur actionnement par des fils en colonnes et des fils en rangés disposés sous forme de matrices et reliés à deux groupes de ports entrées / sorties (PA, PB) d'un microprocesseur (uP), ces deux groupes étant alternativement montés comme entrées et comme sorties en push-pull, les ports respectivement montés comme entrées (PA ou PB) analysant les impulsions de scrutation émises par les ports respectivement montés comme sorties (PB ou PA) et le microprocesseur (uP) pouvant identifier la touche actionnée à partir de la coïncidence d'une impulsion de scrutation générée par cycles au niveau des sorties du microprocesseur avec une entrée activée du microprocesseur, **caractérisé en ce que** le clavier (T) est divisé en quatre groupes de touches (T1, T3, T2, T4) scrutés par les entrées et sorties (PA, PB) du microprocesseur, **caractérisé en outre en ce que** les deux premiers groupes de touches (T1, T3) avec leurs touches (T 111 à Tlmn, T 311 à Tmn) sont reliés avec leurs fils en rangées (R1 à Rm) au premier groupe de ports entrée / sortie (PA1, PA2 à Pam) par des diodes polarisées dans le sens de conduction et avec leurs fils en colonnes (S1 à Sn) au deuxième groupe de ports entrée / sortie (PB1, PB2 à Pbn), **caractérisé également en ce que** les fils en rangées (R1 à Rm) des deux autres groupes de touches (T2, T4) avec leurs touches (T 211,T 212 à T2mn et T 411, T 412 à T 4mn) sont montés sur le premier groupe de ports entrée / sortie (PA1, PA2 à Pam), leurs fils en colonnes (S1 à Sn) étant reliés au deuxième groupe de ports entrée / sortie (PB1, PB2 à Pbn) par des diodes polarisées dans le sens de conduction et **caractérisé enfin en ce que** le premier groupe de touches (T1) et le troisième groupe de touches (T3) et le deuxième (T2) et le quatrième groupe de touches (T4) sont montés en parallèle, des moyens (HP) étant montés dans les fils en rangées (R) du troisième groupe de touches (T3) et dans les fils en colonnes (S) du quatrième groupe de touches (T4).

2. Circuit selon la revendication 1, caractérisé en ce que les moyens de différenciation des groupes de touches sont constitués par des éléments de passe-haut.
